# EUROPEAN PATENT APPLICATION

(11) **EP 4 290 570 A1**
(43) Date of publication of application: **13.12.2023**
(21) Application number: 22756037.2
(22) Date of filing: 08.02.2022
(51) Int. Cl.: H01L 23/12, H01L 21/301, H05K 1/02

(54) **CERAMIC PLATE AND METHOD FOR MANUFACTURING CERAMIC PLATE**

(30) Priority: 18.02.2021 JP 2021024380
(71) Applicant: Denka Company Limited, Tokyo 103-8338 (JP)
(72) Inventor: TSUGAWA, Yuta, Tokyo 103-8338 (JP); FUJIYOSHI, Daiki, Tokyo 103-8338 (JP); YAMAGATA, Toshitaka, Tokyo 103-8338 (JP)
(74) Representative: Gulde & Partner
(86) International application number: PCT/JP2022/004963
(87) International publication number: WO 2022/176716

(57) **Abstract**

A ceramic plate according to an aspect of the present disclosure has a first main surface and a second main surface, and a scribe line constituted by a plurality of holes formed on the first main surface. When a first bending strength is a value measured by a three-point bending test in a state where the first main surface is supported at two fulcrums and the scribe line lies along a load point applied to the second main surface, and when a second bending strength is a value measured by a three-point bending test in a state where the scribe line is not present between the two fulcrums, the first bending strength is 380 MPa or greater and 0.56 times or less the second bending strength.

## Description

### Technical Field

The present disclosure relates to a ceramic plate and a method for manufacturing a ceramic plate.

### Background Art

An insulating ceramic plate is sometimes used for a circuit board mounted in an electronic device. Regarding a method for manufacturing that circuit board, for example, the technology disclosed in Patent Literature 1 is known. In the technology disclosed in Patent Literature 1, after scribe lines are formed on a surface of a ceramic plate using a carbon dioxide gas laser, a YAG laser, or the like, a metal layer is joined to the surface to form a composite substrate. Further, the metal layer on the surface of the composite substrate is etched into a circuit pattern. Thereafter, the composite substrate is divided along a scribe line, and a plurality of circuit boards are thereby manufactured.

### Citation List

### Patent Literature

[Patent Literature 1] Japanese Unexamined Patent Publication No. 2007-324301

### Summary of Invention

### Technical Problem

When a composite substrate is divided along a scribe line, if the strength against bending of a part having the scribe line formed therein is excessively strong, burrs may be formed when the composite substrate is divided, and the quality of a circuit board may be degraded. A step of manufacturing a circuit board includes various steps while a composite substrate is divided along a scribe line after the scribe line is formed. For this reason, if the strength against the foregoing bending is excessively weak, a ceramic plate or a composite substrate may crack during the steps, and a yield rate may deteriorate.

Hence, the present disclosure provides a ceramic plate and a method for manufacturing a ceramic plate useful for achieving both stable quality of a circuit board and improvement in yield rate.

### Solution to Problem

A ceramic plate according to an aspect of the present disclosure has a first main surface and a second main surface, and a scribe line constituted by a plurality of holes formed on the first main surface. When a first bending strength is a value measured by a three-point bending test in a state where at least a part of the ceramic plate is disposed such that the first main surface is supported at two fulcrums and the scribe line lies along a load point applied to the second main surface, and when a second bending strength is a value measured by a three-point bending test in a state where at least a part of the ceramic plate is disposed such that the scribe line is not present between two fulcrums, the first bending strength is 380 MPa or greater and 0.56 times or less the second bending strength.

When a ceramic plate is divided along a scribe line, if the strength against bending of a part having the scribe line formed therein is excessively strong, there is concern that burrs may be formed when the ceramic plate is divided and the quality of a circuit board formed using the ceramic plate may be degraded. Meanwhile, after a ceramic plate is formed, various steps for forming a circuit board are performed. For this reason, if the strength against bending of a part having a scribe line formed therein is excessively weak, there is concern that a ceramic plate may crack during the steps and a yield rate may be degraded. In contrast, in the present ceramic plate, by adjusting the bending strength within the foregoing range regarding the scribe line, the ceramic plate is unlikely to crack, and burrs are unlikely to be formed during division. Therefore, the present ceramic plate is useful for achieving both stable quality of a circuit board and improvement in yield rate.

A longest length of each of the plurality of holes in a direction orthogonal to the scribe line on the first main surface may be 50 µm to 120 µm. A depth of each of the plurality of holes may be 1/6 times to 1/3 times a thickness of the ceramic plate. A pitch of the plurality of holes along the scribe line may be 50 µm to 120 µm. In addition to adjustment of the bending strength, by adjusting the length of the hole, the depth of the hole, and the pitch of the holes within the foregoing range regarding the scribe line, cracking of the ceramic plate in succeeding steps and forming of burrs during division are more reliably curbed. Therefore, it is more useful for achieving both stable quality of a circuit board and improvement in yield rate.

A method for manufacturing a ceramic plate according to another aspect of the present disclosure includes a step of selecting a setting condition from a plurality of processing conditions for forming a scribe line constituted by a plurality of holes on a main surface of a ceramic plate, and a step of forming the scribe line using a laser beam on a surface of a base material for the ceramic plate in accordance with the setting condition. Each of the plurality of processing conditions includes a longest length of each of the plurality of holes in a direction orthogonal to the scribe line on the main surface, a depth of each of the plurality of holes, and a pitch of the plurality of holes along the scribe line. The step of selecting the setting condition includes forming a plurality of ceramic plates for evaluation in accordance with the plurality of processing conditions, each of the plurality of ceramic plates including a scribe line for evaluation constituted by a plurality of holes and formed on one main surface, and selecting a condition having a first bending strength being 380 MPa or greater and 0.56 times or less a second bending strength from the plurality of processing conditions as the setting condition by evaluating a bending strength of each of the plurality of ceramic plates for evaluation. The first bending strength is a value measured by a three-point bending test in a state where at least a part of the ceramic plate for evaluation is disposed such that the one main surface including the scribe line for evaluation formed thereon is supported at two fulcrums and the scribe line for evaluation lies along a load point applied to the other main surface opposite to the one main surface including the scribe line for evaluation formed thereon. The second bending strength is a value measured by a three-point bending test in a state where at least a part of the ceramic plate for evaluation is disposed such that the scribe line for evaluation is not present between two fulcrums.

In this manufacturing method, a condition having the first bending strength being 380 MPa or greater and 0.56 times or less the second bending strength is selected. For this reason, in a ceramic plate having a scribe line formed therein in accordance with the selected condition, the first bending strength can be also adjusted within the foregoing range. If the first bending strength is 380 MPa or greater, the ceramic plate is unlikely to crack in various steps after a scribe line is formed, and if the first bending strength is 0.56 times or less the second bending strength, burrs are unlikely to be formed after being divided. Therefore, this manufacturing method is useful for achieving both stable quality of a circuit board formed using a ceramic plate and improvement in yield rate.

### Advantageous Effects of Invention

According to the present disclosure, a ceramic plate and a method for manufacturing a ceramic plate useful for achieving both stable quality of a circuit board and improvement in yield rate are provided.

### Brief Description of Drawings

FIG. 1 is a perspective view schematically illustrating an example of a ceramic plate according to an embodiment.
FIG. 2 is a schematic view illustrating an example of a cross section of the ceramic plate.
FIG. 3 is a schematic view illustrating another example of a cross section of the ceramic plate.
FIG. 4 is a schematic view illustrating an example of a scribe line.
FIG. 5(a) and FIG. 5(b) are schematic views illustrating examples of the scribe line.
FIG. 6 is a cross-sectional view schematically illustrating an example of the scribe line.
FIG. 7(a) and FIG. 7(b) are schematic explanatory views of a three-point bending test.
FIG. 8 is a flowchart showing an example of a method for manufacturing a circuit board.
FIG. 9 is a perspective view schematically illustrating an example of the ceramic plate having a brazing material applied thereto.
FIG. 10 is a perspective view schematically illustrating an example of a composite substrate.
FIG. 11 is a perspective view schematically illustrating an example of the composite substrate in a state where a resist pattern is formed on a surface thereof.
FIG. 12 is a perspective view schematically illustrating an example of a circuit board.
FIG. 13 is a flowchart showing an example of a method for selecting a condition.

### Description of Embodiment

Hereinafter, an embodiment will be described with reference to the drawings. However, the following embodiment is an explanatory example of the present disclosure, and the present disclosure is not intended to be limited to the following details. In the description, the same reference signs are used for the same elements or elements having the same function, and duplicate description will be omitted depending on the case. In addition, unless otherwise stated, positional relationships such as up, down, left, and right are based on the positional relationships indicated in the drawings. Moreover, the dimensional ratios of each element are not limited to the illustrated ratios.

### [Ceramic plate]

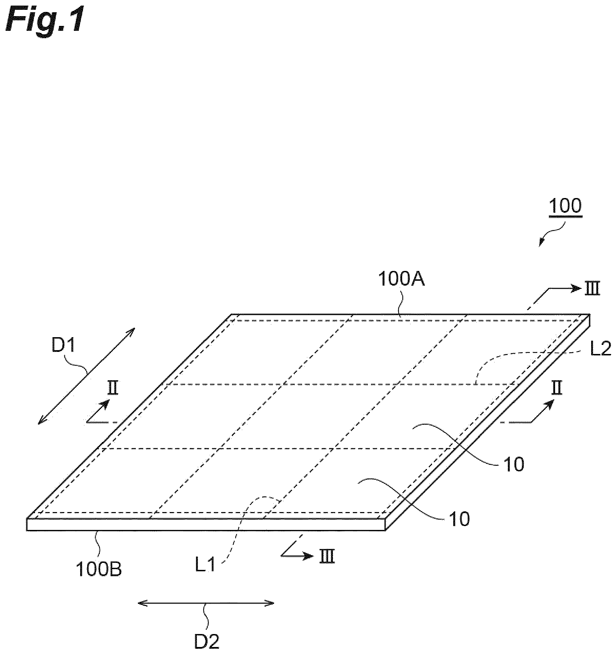

FIG. 1 schematically illustrates an example of a ceramic plate according to an embodiment. A ceramic plate 100 illustrated in FIG. 1 is a silicon nitride plate or an aluminum nitride plate, for example. The ceramic plate 100 has a flat plate shape. The ceramic plate 100 has a main surface 100A and a main surface 100B in directions opposite to each other (facing each other). The main surface 100A is partitioned into a plurality of sections by scribe lines. In the example illustrated in FIG. 1, on the main surface 100A, a plurality of scribe lines L1 and a plurality of scribe lines L2 are formed. For example, when the main surface 100A constitutes a first main surface, the main surface 100B constitutes a second main surface.

Each of the plurality of scribe lines L1 extends in a direction in which one side of the main surface 100A extends (which will hereinafter be referred to as "a direction D1"). The plurality of scribe lines L1 are arranged at equal intervals in a direction along the main surface 100A and orthogonal to the direction D1 (which will hereinafter be referred to as "a direction D2"). Each of the plurality of scribe lines L2 extends along the main surface 100A and in the direction D2. The plurality of scribe lines L2 are arranged at equal intervals in the direction D1. The scribe lines L1 and the scribe lines L2 are orthogonal to each other.

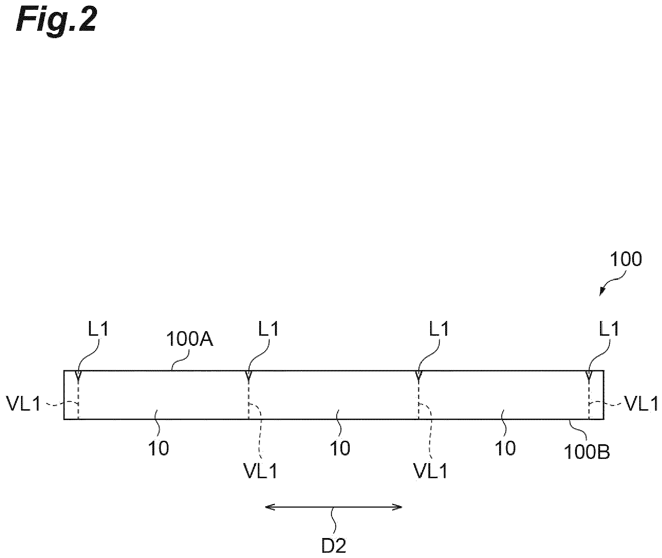

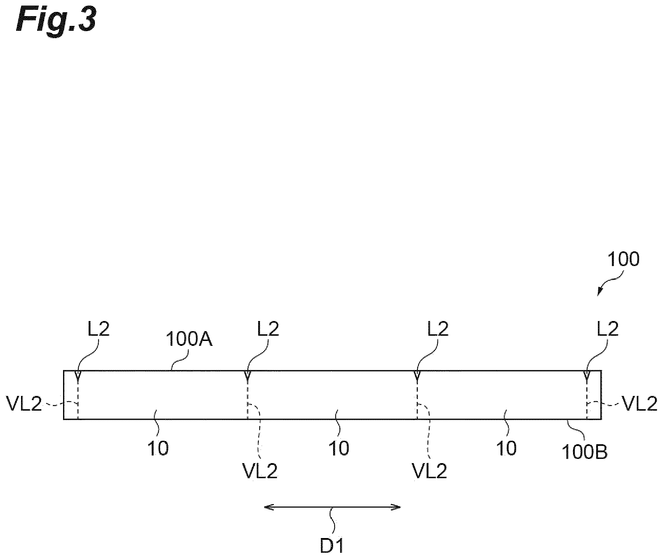

The ceramic plate 100 is partitioned into a plurality of (nine in FIG. 1) partition portions 10 by the plurality of scribe lines L1 and the plurality of scribe lines L2. In other words, the ceramic plate 100 has a plurality of partition portions 10 defined by the scribe lines L1 and the scribe lines L2. FIG. 2 illustrates a cross-sectional view along line II-II indicated in FIG. 1, and FIG. 3 illustrates a cross-sectional view along line III-III indicated in FIG. 1. As illustrated in FIG. 1, FIG. 2, and FIG. 3, each of the plurality of partition portions 10 is constituted of a three-dimensional region. That three-dimensional region is surrounded by a region of the main surface 100A surrounded by the scribe lines L1 and L2, a region of the main surface 100B on the other side corresponding to that region of the main surface 100A, and by virtual lines VL1 and VL2 drawn parallel to a thickness direction of the ceramic plate 100 from the scribe lines L1 and L2.

In the ceramic plate 100 illustrated in FIG. 1, FIG. 2, and FIG. 3 as an example, the scribe lines L1 and L2 are formed on the main surface 100A without being formed on the main surface 100B, but locations for forming scribe lines are not limited to this. Ones of the scribe lines L1 and L2 or both the scribe lines L1 and L2 may be formed on both the main surface 100A and the main surface 100B opposite to the main surface 100A.

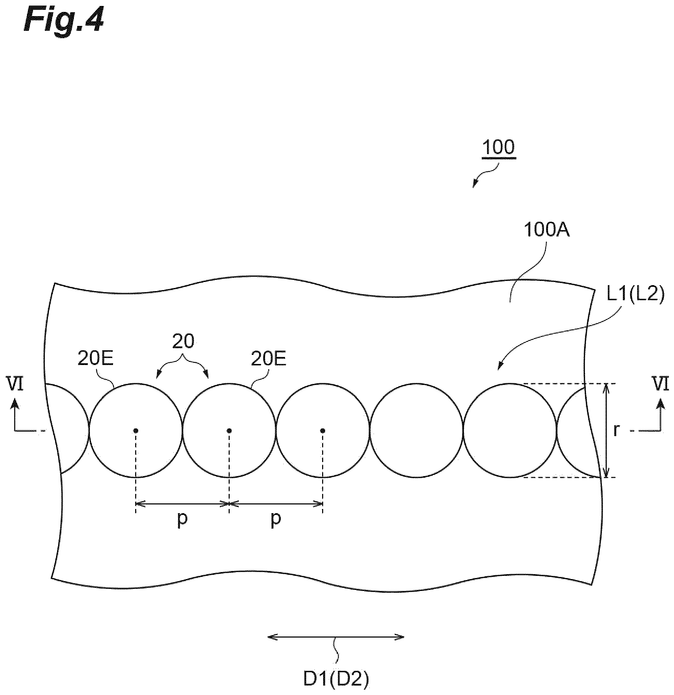

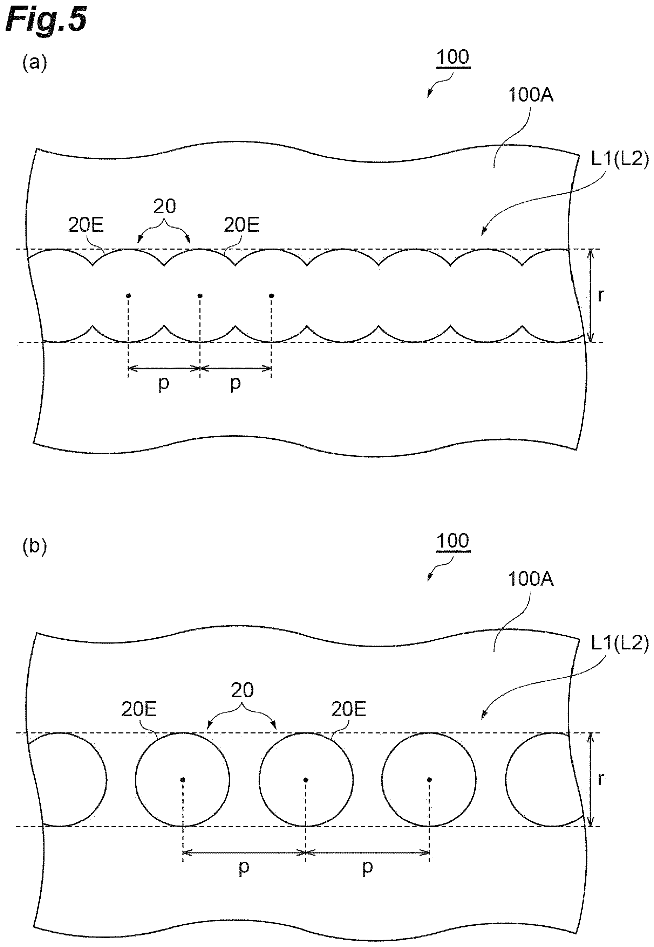

In FIG. 4 and FIG. 5, the scribe line L1 (L2) provided in a part on the main surface 100A is illustrated in an enlarged manner. The scribe line L1 is constituted by a plurality of holes 20 arranged in a line in a longitudinal direction of the scribe line L1 (the direction D1). Similarly, the scribe line L2 is also constituted by a plurality of holes 20 arranged in a line in a longitudinal direction of the scribe line L2 (the direction D2). Holes 20 adjacent to each other may be connected to each other and may be separated from each other. Opening edges 20E of the holes 20 on the main surface 100A (outer edges of the holes 20 on the main surface 100A) may have a circular shape when viewed in a direction orthogonal to the main surface 100A.

FIG. 4 illustrates, as an example, a case where a pitch of the plurality of holes 20 (which will hereinafter be referred to as "an array pitch p") arranged in the longitudinal direction of the scribe line L1 substantially coincides with a diameter of the hole 20. FIG. 5(a) illustrates, as an example, a case where a part of the hole 20 overlaps another adjacent hole 20 in a state where the holes 20 adjacent to each other are connected to each other. In this case, a part of the opening edge 20E of one hole 20 is cut out by another hole 20. For this reason, the opening edge 20E of one hole 20 does not have a perfect circular shape and has an arc shape. FIG. 5(b) illustrates, as an example, a case where the holes 20 adjacent to each other are separated from each other.

From a viewpoint of smooth division along the scribe line L1 and the scribe line L2, an opening size r of each of the plurality of holes 20 on the main surface 100Amay be 50 µm or larger, may be 60 µm or larger, or may be 70 µm or larger. From a viewpoint of maintaining a mechanical strength of the ceramic plate 100, the opening size r of each of the holes 20 may be 120 µm or smaller, may be 110 µm or smaller, or may be 100 µm or smaller. The opening size r of each of the plurality of holes 20 on the main surface 100A may be 50 µm to 120 µm or may be 60 µm to 110 µm.

The opening size r of each of the holes 20 of the scribe line L1 corresponds to the longest length of the hole 20 in a direction orthogonal to the scribe line L1 on the main surface 100A (the largest width orthogonal to the scribe line L1 of diverse opening widths on the main surface 100A). The opening size r of each of the holes 20 of the scribe line L2 corresponds to the longest length of the hole 20 in a direction orthogonal to the scribe line L2 on the main surface 100A. When the opening edges 20E of the holes 20 have a circular shape, the opening size r of each of the holes 20 corresponds to the diameter of the opening edge 20E. Since the holes 20 adjacent to each other have an arc shape when they are connected to each other, the opening size r corresponds to the size (diameter) of the opening edge 20E in a direction orthogonal to the longitudinal direction of the scribe line. The opening size r of each of the plurality of holes 20 (the diameter of the opening edge 20E) may substantially coincide with each other or may differ from each other.

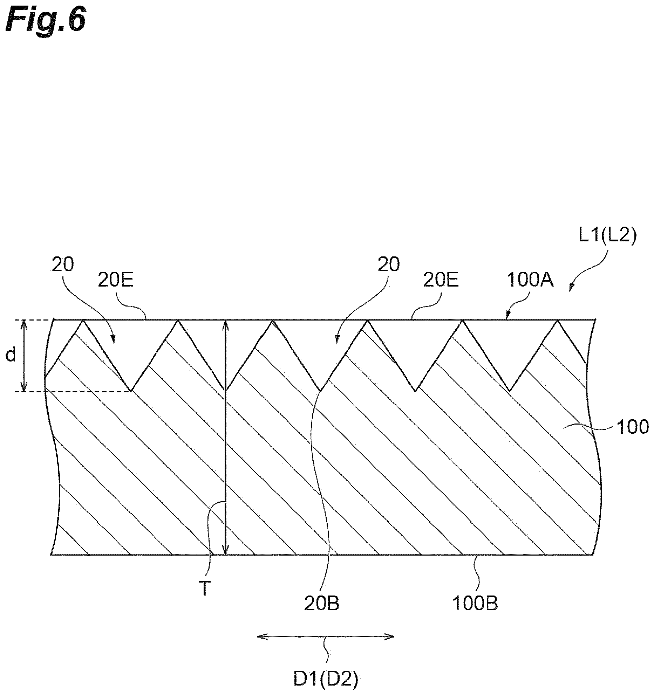

FIG. 6 illustrates a cross-sectional view along line VI-VI indicated in FIG. 4. That is, FIG. 6 is a cross-sectional view when the ceramic plate 100 is cut along a plane passing through the center of each of the holes 20 of the scribe line L1 (L2) and perpendicular to the main surface 100A. Each of the holes 20 has a mortar shape in a manner of being tapered toward the inside of the ceramic plate 100 from the main surface 100A (opening edge 20E). From a viewpoint of smooth division along the scribe line L1 and the scribe line L2, a depth d of each of the plurality of holes 20 may be 1/6 times or more a thickness T of the ceramic plate 100, may be 115 times or more the thickness T, or may be 1/4 times or more the thickness T.

From a viewpoint of maintaining the mechanical strength of the ceramic plate 100, the depth d of each of the holes 20 may be 1/3 times or less the thickness T of the ceramic plate 100, may be 3/10 times or less the thickness T, or may be 4/15 times or less the thickness T. For example, the depth d may be 1/6 times to 1/3 times the thickness T of the ceramic plate 100 or may be 115 times to 3/10 times the thickness T. In an example, when the thickness T of the ceramic plate 100 is 0.15 mm to 1 mm, the depth d may be 25 µm to 330 µm, may be 50 µm to 200 µm, or may be 60 µm to 100 µm. As illustrated in FIG. 6, the depth d is defined by a distance of the ceramic plate 100 in the thickness direction from the main surface 100A (opening edge 20E) to bottom portion 20B (lowermost points) of the hole 20. The depth d of each of the plurality of holes 20 may substantially coincide with each other or may differ from each other.

From a viewpoint of maintaining the mechanical strength of the ceramic plate 100, the array pitch p of the plurality of holes 20 (refer to FIG. 4) may be 50 µm or longer, may be 60 µm or longer, or may be 70 µm or longer. From a viewpoint of smooth division along the scribe lines, the array pitch p may be 120 µm or shorter, may be 110 µm or shorter, or may be 100 µm or shorter. For example, the array pitch p may be 50 µm to 120 µm or may be 60 µm to 110 µm. The array pitch p may be 0.42 times or larger, 0.5 times or larger, or 0.6 times or larger the opening size r. The array pitch p may be 2.4 times or smaller, 2.0 times or smaller, or 1.8 times or less the opening size r. The array pitch p along the scribe line of the plurality of holes 20 is defined by a distance between the centers of the holes 20 adjacent to each other along the scribe line. The plurality of holes 20 may be arranged along the scribe line such that the array pitch p becomes substantially uniform or may be arranged along the scribe line such that the array pitch p partially differs.

A physical strength against bending of a part having the scribe line L1 or the scribe line L2 formed therein can be evaluated by measuring a bending strength of the ceramic plate 100 by a three-point bending test. In the present disclosure, the bending strength of the ceramic plate is a value measured by the three-point bending test in conformity with JIS R 1601-2008.

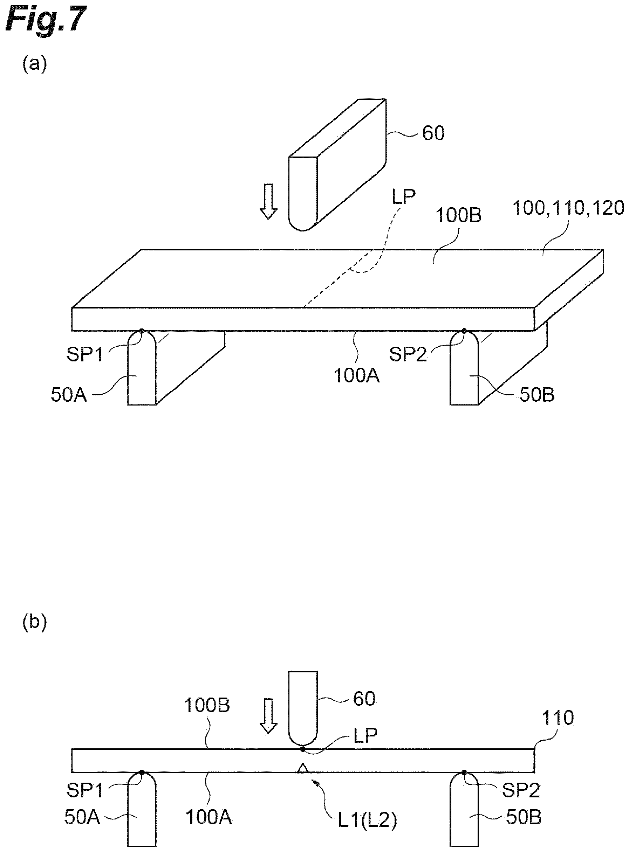

More specifically, as illustrated in FIG. 7(a), in a state where one main surface of a test piece obtained by cutting out a part of the ceramic plate 100 is supported by two support bodies 50A and 50B, while a load is caused to act on the other main surface using an anvil 60, the bending strength of the test piece (ceramic plate) is measured. A load point LP (load line) acting on the test piece by means of the anvil 60 is set in a manner of extending in a direction orthogonal to the direction in which the support bodies 50A and 50B are arranged. The support bodies 50A and 50B and the anvil 60 are disposed such that the load point LP is positioned between two fulcrums SP1 and SP2 (two support lines) of the two support bodies 50A and 50B. Further, a load is caused to act on the test piece from the anvil 60 while the load is increased, and the value of the load when the test piece cracks (ruptures) is measured as the bending strength.

In the ceramic plate 100 according to the present disclosure, when a first bending strength N1 is a measurement value that is defined as follows, the first bending strength N1 is 380 MPa or greater. The mechanical strength of the ceramic plate 100 is maintained by setting the first bending strength N1 to 380 MPa or greater.

First bending strength N1: a value measured by a three-point bending test in a state where a test piece of the ceramic plate 100 is disposed such that the main surface 100A having the scribe line L1 (L2) formed thereon is supported by two fulcrums SP1 and SP2 and the scribe line L1 (L2) lies along the load point LP applied to the main surface 100B

FIG. 7(b) illustrates an example of disposition of the test piece of the ceramic plate 100 (which will hereinafter be referred to as "a test piece 110") when the first bending strength N1 is measured. As illustrated in FIG. 7(b), on the main surface 100B, a load is applied by the anvil 60 at a position corresponding to the scribe line L1 (L2) on the main surface 100A. In the test piece 110, main surfaces respectively corresponding to the main surfaces 100A and 100B will also be described as "the main surfaces 100A and 100B". For example, the test piece 110 is cut out from the ceramic plate 100 such that one side of the test piece 110 is 40 mm and the scribe line L1 (L2) is positioned substantially at the center. The first bending strength N1 may be 385 MPa or greater, 390 MPa or greater, 395 MPa or greater, or 400 MPa or greater.

In addition, in the ceramic plate 100, when a second bending strength N2 is a measurement value that is defined as follows, the first bending strength N1 is 0.56 times or less the second bending strength N2. The ceramic plate 100 is smoothly divided along the scribe line by setting the first bending strength N1 to 0.56 times or less the second bending strength N2.

Second bending strength N2: a value measured by a three-point bending test in a state where the test piece of the ceramic plate 100 is disposed such that the scribe line L1 (L2) is not present between two fulcrums SP1 and SP2

The test piece of the ceramic plate 100 when the second bending strength N2 is measured (which will hereinafter be referred to as "a test piece 120") differs from the foregoing test piece 110 and has no scribe line. For example, in the ceramic plate 100, the test piece 120 is formed by cutting out a region having neither of the scribe lines L1 and L2 formed therein. Alternatively, the test piece 120 is formed from the ceramic plate 100 in a state before the scribe lines L1 and L2 are formed. That is, the second bending strength N2 measured using the test piece 120 indicates the bending strength of a base material itself constituting the ceramic plate 100.

When the second bending strength N2 is 700 MPa to 1,000 MPa, the first bending strength N1 may be 392 MPa to 560 MPa. In an example, when the second bending strength N2 is 750 MPa, the first bending strength N1 may be 380 MPa to 420 MPa or may be 385 MPa to 415 MPa. The first bending strength N1 may be 0.54 times or smaller, 0.52 times or smaller, or 0.50 times or less the second bending strength N2.

In the foregoing ceramic plate 100, the opening size r of each of the plurality of holes 20, the depth d of each of the plurality of holes 20, and the array pitch p of the plurality of holes 20 are adjusted such that the first bending strength N1 becomes 380 MPa or greater and 0.56 times or less the second bending strength N2. Specific examples of a method for adjusting these dimensions will be described below. In an example, the ceramic plate 100 (scribe lines L1 and L2) is formed such that all the first bending strength N1, the opening size r, the depth d, and the array pitch p are within respective numerical value ranges described above. In such a ceramic plate 100, both maintaining of the mechanical strength and smooth division along the scribe line L1 and the scribe line L2 are achieved.

As the depth d increases, the first bending strength N1 tends to decrease and a difference in strength with respect to the second bending strength N2 tends to increase. As the opening size r increases, the first bending strength N1 tends to decrease and a difference in strength with respect to the second bending strength N2 tends to increase. As the array pitch p decreases, the first bending strength N1 tends to decrease and a difference in strength with respect to the second bending strength N2 increases. In the foregoing description, adjustment of the depth d, the array pitch p, and the opening size r has been described as an example, but the value of the first bending strength N1 (the relationship with respect to the second bending strength N2) may be adjusted by a method of adjusting the opening area, the depth, the pitch, and the like by changing the shapes of the holes to other shapes such as polygons including ellipses, rectangular shapes, or the like instead of circles.

When the main surfaces 100A and 100B of the ceramic plate 100 have a rectangular shape, the length of a short side of the ceramic plate 100 is 100 mm or longer, for example. The length of the short side of the ceramic plate 100 may be 110 mm or longer, may be 130 mm or longer, or may be 150 mm or longer. The length of a long side of the ceramic plate 100 is 150 mm or longer, for example. The length of the long side of the ceramic plate 100 may be 170 mm or longer, may be 190 mm or longer, or may be 220 mm or longer. The main surfaces 100A and 100B may be squares having a length of one side of 100 mm to 220 mm.

In the ceramic plate 100, the length of the short side thereof may be 100 mm to 150 mm and the length of the long side thereof may be 150 mm to 220 mm. In this case, in order to maintain the mechanical strength of the ceramic plate 100, the first bending strength N1 is adjusted to 380 MPa or greater. In the ceramic plate 100, the length of the short side thereof may exceed 150 mm and the length of the long side thereof may exceed 220 mm. In this case, in order to maintain the mechanical strength of the ceramic plate 100, the first bending strength N1 may be adjusted to 400 MPa or greater.

### [Manufacturing method]

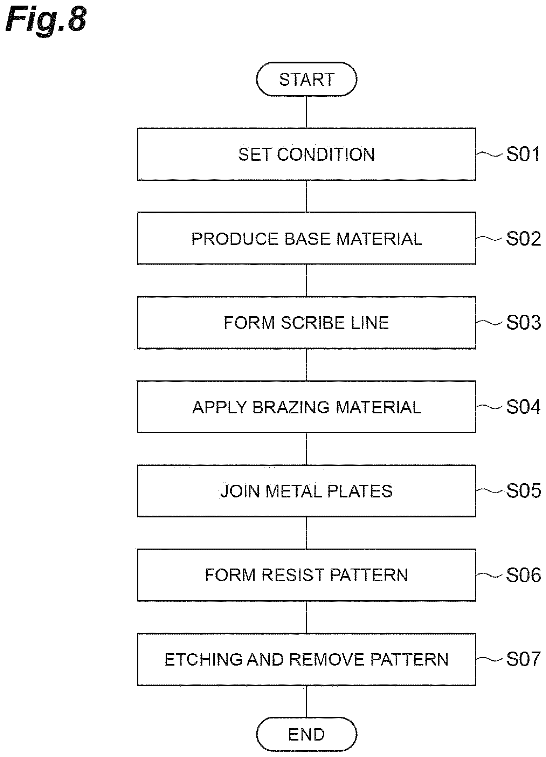

Subsequently, a method for manufacturing a circuit board according to an embodiment will be described. A process of manufacturing this circuit board includes a step of manufacturing the ceramic plate 100 (manufacturing method of the ceramic plate 100). FIG. 8 is a flowchart showing an example of a method for manufacturing a circuit board. In this manufacturing method, first, a condition is selected (determined) from a plurality of processing conditions for forming scribe lines on the main surface 100A of the ceramic plate 100 (S01). In other words, in succeeding steps, the scribe lines L1 and L2 are formed on the main surface 100A in accordance with the selected condition (which will hereinafter be referred to as "a setting condition"). The processing conditions for forming scribe lines include the opening size r of each of the plurality of holes 20 on the main surface 100A, the depth d of each of the plurality of holes 20, and the array pitch p of the plurality of holes 20 along the scribe line L1 (L2). Details of the method for selecting a setting condition will be described below.

Next, a base material including a ceramic material (for example, a silicon nitride powder or an aluminum nitride powder) is produced (S02). For example, the base material can be manufactured through the following procedure. First, a green sheet is obtained by molding a slurry including a silicon nitride powder or an aluminum nitride powder, a binder resin, a sintering aid, a plasticizer, a dispersant, a solvent, and the like. Examples of a sintering aid include rare earth metal, alkaline earth metal, metal oxide, fluoride, chloride, nitrate, and sulfate. Regarding these, only one kind may be used, or two or more kinds may be used together. Sintering of an inorganic compound powder can be promoted by using a sintering aid. Examples of a binder resin include methyl cellulose, ethyl cellulose, polyvinyl alcohol, polyvinyl butyral, and (meth)acrylic resin.

Examples of a plasticizer include phthalate-based plasticizers such as refined glycerin, glycerin trioleate, diethylene glycol, and di-n-butyl phthalate; and dibasic acid-based plasticizers such as di-2-ethylhexyl sebacate. Examples of a dispersant include poly(meth)acrylate and (meth)acrylic acid-maleate copolymer. Examples of a solvent include organic solvents such as ethanol and toluene.

Examples of a method for molding a slurry include a doctor blade method and an extrusion molding method. A green sheet is produced by such a method. Thereafter, degreasing and sintering of the green sheet are performed, and a base material including silicon nitride or aluminum nitride is thereby obtained. For example, degreasing may be performed by heating the green sheet at 400°C to 800°C for 0.5 to 20 hours. Consequently, while oxidation and deterioration of silicon nitride or aluminum nitride are curbed, a residual amount of organic matter (carbon) can be reduced. Sintering may be performed by heating the green sheet at 1,700°C to 1,900°C under an atmosphere of non-oxidizing gas such as nitrogen, argon, ammonia, or hydrogen.

Degreasing and sintering described above may be performed in a state where a plurality of green sheets are stacked. When degreasing and sintering are performed by stacking them, release layers made of release agents may be provided between green sheets in order to smoothly separate sheets after baking. For example, boron nitride (BN) can be used as release agents. For example, release layers may be formed by applying a slurry of powder of boron nitride by a method such as spraying, brushing, roll coating, or screen printing. From the viewpoint of causing degreasing to sufficiently progress while mass production of the base material is efficiently performed, the number of green sheets to be stacked may be 10 to 100 sheets or may be 20 to 80 sheets, for example.

Next, with respect to a surface of the base material obtained in the foregoing step (S02), a step of forming scribe lines (S03) is performed using a laser beam in accordance with the condition set in the step (S01). Specifically, the ceramic plate 100 having the scribe lines L1 and L2 on the main surface 100A as illustrated in FIG. 1 to FIG. 3 is formed by forming a plurality of holes on the surface of the base material obtained in the step (S02) through irradiation with a laser beam. Examples of a laser beam include a carbon dioxide gas laser, a YAG laser, and a fiber laser. Each of the plurality of holes 20 illustrated in FIG. 4 and FIG. 5 is formed by performing irradiation a plurality of times with a laser beam. Consequently, compared to a case where each hole is formed by performing irradiation only once, an energy of an irradiation laser beam per time can be reduced. Therefore, a laser beam can be efficiently utilized for forming the holes 20, and thus degeneration due to scorching of silicon nitride or aluminum nitride can be curbed.

The holes 20 may be formed in a burst pulse mode or may be formed in a cycle pulse mode. The burst pulse mode is performed in the following procedure. A first hole 20 is formed by irradiating the same position a plurality of times with a laser beam. Subsequently, a second hole 20 is formed adjacent to the first hole 20 by performing irradiation a plurality of times with a laser beam. Consequently, two holes 20 adjacent to each other are formed. By repeating that procedure a plurality of times, n holes 20 are formed (n is a positive integer equal to or larger than 2). In this manner, the scribe line L1 (L2) constituted by the n holes 20 can be formed. When irradiation is performed twice with a laser beam in order to form one hole 20, irradiation is performed (2×n) times with a laser beam in order to form the n holes 20.

For example, the cycle pulse mode is performed through the following procedure. Each of the first to nth holes 20 is formed by performing irradiation once with a laser beam. Thereafter, the first to nth holes 20 are irradiated once again with a laser beam. In this case as well, irradiation is performed (2×n) times with a laser beam in order to form the n holes 20. In order to form each of the holes 20, irradiation may be performed three or more times with a laser beam. From the viewpoint of work efficiency, in order to form each of the holes 20, the number of times of irradiation with a laser beam may be ten times or fewer. The method for forming the holes 20 is not limited to the two methods described above. For example, the burst pulse mode and the cycle pulse mode may be combined.

An irradiation interval of a plurality of times of irradiation performed with a laser beam in order to form one hole 20 may be 1,200 microseconds or longer (850 Hz or lower) or 1,500 microseconds or longer (670 Hz or lower) in order to secure a cooling time of the ceramic plate 100 heated by irradiation with a laser beam.

The energy of irradiation with a laser beam per time may be smaller than 70 mJ, may be 50 mJ or smaller, or may be 30 mJ or smaller. Scorching (generation of an oxygen-rich layer that is foreign matter) of the ceramic plate can be curbed by reducing the energy of irradiation per time in this manner. From a viewpoint of efficiently forming the holes 20, the energy of irradiation with a laser beam per time may be 5 mJ or greater or may be 10 mJ or greater.

From a viewpoint of reducing damage to the ceramic plate 100 while the holes 20 having sufficient sizes are formed on the main surface 100A of the ceramic plate 100, a pulse width of the laser beam may be 30 microseconds to 200 microseconds or may be 50 microseconds to 150 microseconds.

The ceramic plate 100 can be obtained by forming the scribe lines L1 and L2 in this manner. The scribe lines L1 and L2 become cut lines when the ceramic plate 100 (circuit board) is divided in a succeeding step. As above, the method for manufacturing the ceramic plate 100 includes the steps (S01 to S03) described above.

Next, a step (S04) of applying a paste brazing material is performed with respect to the pair of main surfaces 100A and 100B of the ceramic plate 100. For example, a paste brazing material is applied to the main surfaces 100A and 100B of the ceramic plate 100 by a method such as a roll coater method, a screen printing method, or a transfer method. For example, a brazing material contains a metal component such as silver or titanium, an organic solvent, a binder, and the like. For example, a viscosity of the brazing material may be 5 Pa·s to 20 Pa·s. For example, the organic solvent content in the brazing material may be 5 mass% to 25 mass%, and for example, the binder content may be 2 mass% to 15 mass%.

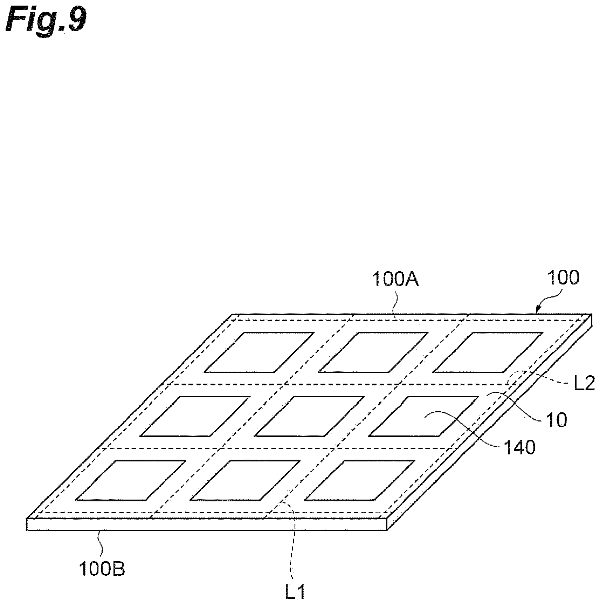

FIG. 9 is a perspective view illustrating an example of the ceramic plate 100 having a brazing material 140 applied thereto. As illustrated in FIG. 9, the brazing material 140 may be independently applied for each of the partition portions 10. FIG. 9 illustrates only the main surface 100A side, but the brazing material 140 may also be applied to the main surface 100B side in a similar manner. The brazing material may be applied to the entire surfaces of the main surface 100A and the main surface 100B.

Next, a step (S05) of forming a composite substrate is performed by joining a pair of metal plates to the ceramic plate 100 having the brazing material 140 applied thereto. For example, in the step (S05), first, a joint body is obtained by bonding metal plates to the main surface 100A and the main surface 100B of the ceramic plate 100 having the brazing material 140 applied thereto. Thereafter, a composite substrate is obtained by heating the joint body in a heating furnace to sufficiently join the ceramic plate 100 and the pair of metal plates to each other.

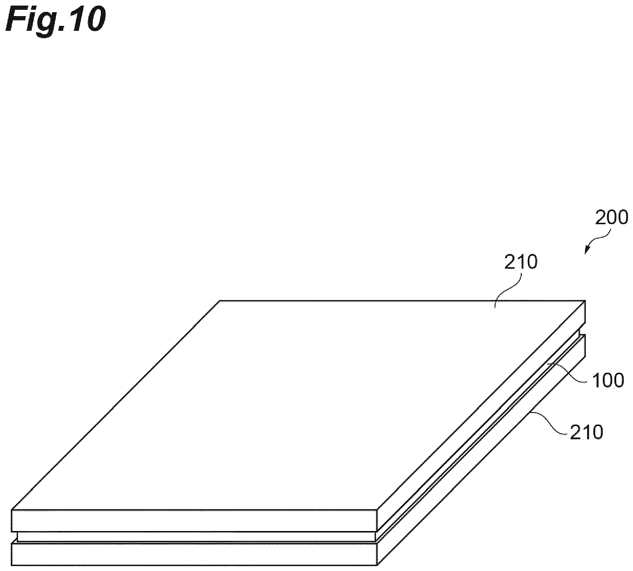

FIG. 10 is a perspective view illustrating an example of a composite substrate according to an embodiment. A composite substrate 200 includes a pair of metal plates 210 disposed in a manner of facing each other, and the ceramic plate 100 positioned between the pair of metal plates 210. The pair of metal plates 210 are joined to the ceramic plate 100 such that the main surface 100A and the main surface 100B of the ceramic plate 100 are covered. Examples of the metal plate 210 include copper plate. The shapes and the sizes of these between the ceramic plate 100 and the metal plate 210 may be the same as each other or may differ from each other. As above, the method for manufacturing the composite substrate 200 includes the steps (S01 to S05) described above.

Next, a step (S06) of forming a resist pattern is performed. For example, in the step (S06), a resist pattern is formed by photolithography. Specifically, first, a photosensitive resist is printed on a surface of the composite substrate. Further, a resist pattern having a predetermined shape is formed using an exposure device. The resist may be a negative type or may be a positive type. For example, an uncured resist is removed by cleaning.

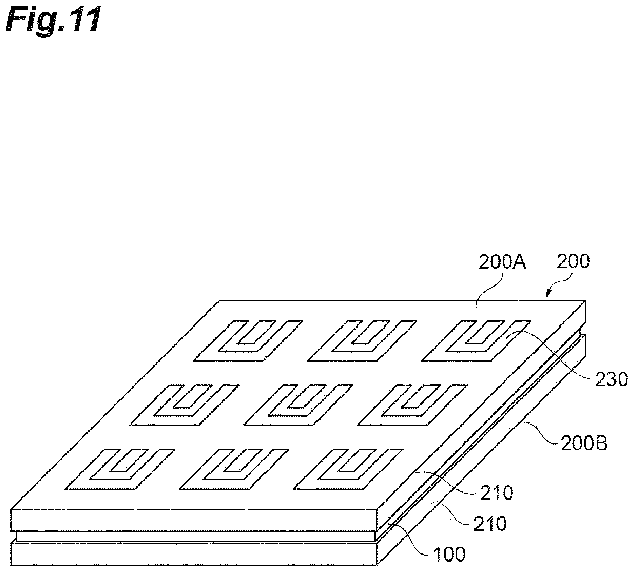

FIG. 11 is a perspective view illustrating an example of the composite substrate 200 in which a resist pattern 230 is formed on a surface 200A. FIG. 11 illustrates only the surface 200A side, but a resist pattern may also be formed on a surface 200B side in a similar manner. The resist pattern 230 is formed in a region corresponding to each of the partition portions 10 of the ceramic plate 100 on the surface 200A and the surface 200B.

Next, an etching step (S07) of removing a part of the metal plate 210 which is not covered by the resist pattern 230 is performed. The main surface 100A and the main surface 100B of the ceramic plate 100 are exposed in the part by performing etching. Thereafter, an independent conductive portion is formed for each of the partition portions 10 by removing the resist pattern 230. The circuit board is obtained through the foregoing steps (S01 to S07).

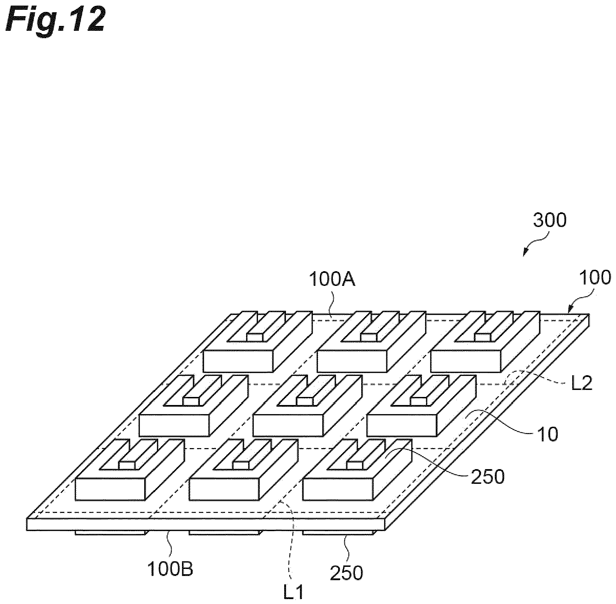

FIG. 12 is a perspective view illustrating an example of a circuit board 300 according to an embodiment. The circuit board 300 includes the ceramic plate 100 and conductive portions 250 disposed in a manner of facing each other with the ceramic plate 100 sandwiched therebetween. The conductive portions 250 are independently provided on the main surface 100A and the main surface 100B for each of the partition portions 10. That is, a pair of conductive portions 250 disposed in a manner of facing each other are provided for each of the partition portions 10.

The circuit board 300 is divided (cut) along the scribe lines L1 and L2 and divided into a plurality of divided boards. For example, each of the divided boards (each circuit board in a divided state) is used as a component of a power module or the like. For example, electronic components are mounted on the conductive portions 250 of the divided boards.

### (Setting of conditions)

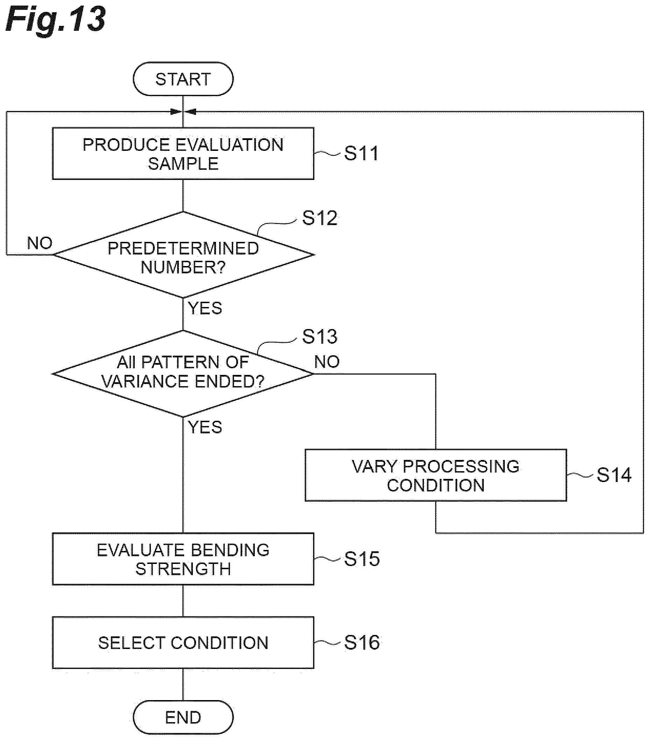

FIG. 13 is a flowchart showing an example of a method for setting a condition in the step (S01) described above. In this method for setting a condition, at least one of various conditions (respective setting values of the opening size r, the depth d, and the array pitch p) included in processing conditions are varied in a plurality of stages, and a plurality of ceramic plates for evaluation are produced as evaluation samples for each stage of variance. In a plurality of processing conditions under which a plurality of ceramic plates for evaluation are produced, at least one of the various conditions is set to values different from each other. In the following description, a case where the array pitch p is varied in stages while the opening size r and the depth d are fixed to a constant value will be described. A condition to be varied and a range of variance may be set in advance by a worker or the like.

First, after the processing condition are set to initial values, a ceramic plate for evaluation is produced by forming scribe lines for evaluation constituted by a plurality of holes in accordance with the processing condition (S11). Further, ceramic plates for evaluation are repeatedly produced under the same processing condition until a predetermined number of (for example, 2 to 10 plates) ceramic plates for evaluation are produced under one processing condition (S11, S12). Accordingly, a plurality of ceramic plates for evaluation formed under the same processing condition are produced, and for example, evaluation items (which will be described below) can be evaluated using average values.

After a predetermined number of ceramic plates for evaluation are produced under one processing condition, and when all patterns (combination of processing conditions) of varying the array pitch p in a plurality of stages has not ended, the processing condition are varied (S13, S14). Further, a plurality of ceramic plates for evaluation are produced in accordance with the varied processing condition. The foregoing steps are repeated until all of the pattern of varying the array pitch p in a plurality of stages ends.

Next, evaluation of bending strengths of the plurality of ceramic plates for evaluation is performed (S15). Specifically, first, the second bending strength N2 described above (the strength against bending of the base material itself not affected by the scribe lines) is measured by a three-point bending test for the ceramic plates for evaluation. When the second bending strength N2 is measured, any of the ceramic plates for evaluation may be used. The second bending strength N2 may be measured before a step (S11). Next, for each stage in which the array pitch p is varied (for each processing condition), the first bending strength N1 (the strength against bending of a part having the scribe lines formed therein) is measured by a three-point bending test. A method for measuring a bending strength in the ceramic plates for evaluation is similar to the measurement method in the ceramic plate 100 described above. For example, for each stage in which the array pitch p is varied, the first bending strength N1 is measured by the three-point bending test using a test piece obtained from each of the plurality of ceramic plates for evaluation. Further, the average value of the measurement values of the respective test pieces obtained from the plurality of ceramic plates for evaluation is calculated as the first bending strength N1 in the stage (processing condition).

Next, from the varied processing conditions (from the plurality of processing conditions), a condition having the first bending strength N1 included in a predetermined numerical value range is selected as a setting condition (S16). More specifically, from the plurality of stages (values) in which the array pitch p is varied, a value having the first bending strength N1 of 380 MPa or greater and 0.56 times or less the second bending strength N2 is selected. When there are a plurality of conditions which are included in the foregoing numerical value range, any one value may be selected by a worker. Through the foregoing steps (S11 to S16), a combination of various conditions in which the first bending strength N1 is 380 MPa or greater and 0.56 times or less the second bending strength N2 are selected. Further, as described above, the scribe lines L1 and L2 are formed on the main surface 100A in accordance with the selected condition (the setting condition).

### (Condition Setting Example 1)

Subsequently, an example of setting various conditions for forming scribe lines will be described. In Setting Example 1, the opening sizes r of the holes 20 were fixed at 60 µm and the depths d of the holes 20 were fixed at 70 µm, ceramic plates for evaluation were produced using a carbon dioxide gas laser-type processing machine while varying the array pitch p in five stages. Five ceramic plates for evaluation were produced for each of the stages (each of the processing conditions) in which the array pitch p was varied. The plate thickness of each ceramic plate for evaluation was 0.32 mm. The following Table 1 shows values of the array pitch p varied in five stages, evaluation results of the first bending strength N1, and ratios of the first bending strength N1 and the second bending strength N2.

**[Table 1]**

| | Condition 1 | Condition 2 | Condition 3 | Condition 4 | Condition 5 |
|---|---|---|---|---|---|
| Array pitch p (µm) | 40 | 60 | 70 | 80 | 90 |
| First bending strength N1 (MPa) | 363 | 396 | 406 | 441 | 463 |
| N1/N2 | 0.48 | 0.53 | 0.54 | 0.59 | 0.62 |

In Table 1, the evaluation result of the first bending strength N1 is the average value of the first bending strengths N1 measured respectively for the five ceramic plates for evaluation. The second bending strength N2 indicating the bending strength of the base material itself in the ceramic plates for evaluation was 750 MPa. From the foregoing evaluation results, in Condition 2 and Condition 3, the first bending strength N1 was included in the range of 380 MPa to 420 MPa (0.56 times the second bending strength N2). Therefore, in this case, 60 µm or 70 µm was selected as the setting value of the array pitch p.

In the ceramic plates for evaluation produced under Condition 1, in succeeding steps after the scribe lines were formed, cracking occurred in some ceramic plates during the steps. In addition, in some ceramic plates for evaluation produced under Condition 4 and Condition 5, burrs (burrs of approximately several hundred µm) were formed after being divided. In the ceramic plates for evaluation produced under Conditions 2 and 3, cracking did not occur in the ceramic plates in succeeding steps after the scribe lines were formed, and burrs were not formed after being divided.

### (Condition Setting Example 2)

In Setting Example 2, the opening sizes r of the holes 20 were fixed at 100 µm and the depths d of the holes 20 were fixed at 70 µm and ceramic plates for evaluation were produced using a fiber laser-type processing machine while varying the array pitch p in five stages. Five ceramic plates for evaluation were produced for each of the stages (each of the processing conditions) in which the array pitch p was varied. The following Table 2 shows values of the array pitch p varied in five stages, evaluation results of the first bending strength N1, and ratios of the first bending strength N1 and the second bending strength N2.

**[Table 2]**

| | Condition 1 | Condition 2 | Condition 3 | Condition 4 | Condition 5 |
|---|---|---|---|---|---|
| Array pitch p (µm) | 60 | 85 | 100 | 115 | 130 |
| First bending strength N1 (MPa) | 343 | 387 | 383 | 381 | 435 |
| N1/N2 | 0.46 | 0.52 | 0.51 | 0.51 | 0.58 |

In Table 2, the evaluation result of the first bending strength N1 is the average value of the first bending strengths N1 measured respectively for the five ceramic plates for evaluation. The second bending strength N2 in the ceramic plates for evaluation was 750 MPa. From the foregoing evaluation results, in Conditions 2, Condition 3, and Condition 4, the first bending strength N1 was included in the range of 380 MPa to 420 MPa. Therefore, in this case, 85 µm, 100 µm, or 115 µm was selected as the setting value of the array pitch p.

In the ceramic plates for evaluation produced in Condition 1, in succeeding steps after the scribe lines were formed, cracking occurred in some ceramic plates during the steps. In addition, in some ceramic plates for evaluation produced under Condition 5, burrs (burrs of approximately several hundred µm) were formed after being divided. In the ceramic plates for evaluation produced under Conditions 2 to 4, cracking did not occur in the ceramic plates in succeeding steps after the scribe lines were formed, and burrs were not formed after being divided.

### [Effects of embodiment]

The ceramic plate 100 according to the embodiment described above is a ceramic plate having the main surface 100A and the main surface 100B, and the scribe lines L1 and L2 constituted by the plurality of holes 20 formed on the main surface 100A. When the first bending strength N1 is a value measured by a three-point bending test in a state where at least a part of the ceramic plate 100 is disposed such that the main surface 100A is supported at the two fulcrums SP1 and SP2 and the scribe lines L1 and L2 lie along the load point LP applied to the main surface 100B, and when the second bending strength N2 is a value measured by a three-point bending test in a state where at least a part of the ceramic plate 100 is disposed such that the scribe line is not present between the two fulcrums SP1 and SP2, the first bending strength N1 is 380 MPa or greater and 0.56 times or less the second bending strength N2.

When the ceramic plate is divided along the scribe line, if the strength against bending of a part having the scribe line formed therein is excessively strong, there is concern that burrs will be formed when the ceramic plate is divided and the quality of circuit boards formed using the ceramic plates will be degraded. On the other hand, steps after the ceramic plates are formed include various steps (for example, described above S04 to S07) in order to form the circuit boards. For this reason, if the foregoing strength against bending is excessively weak, there is concern that the ceramic plates will crack during the steps and a yield rate will deteriorate. In contrast, in the ceramic plate 100 described above, the ceramic plate 100 is unlikely to crack in various steps after the scribe lines are formed by adjusting the lower limit value for the first bending strength N1 to the foregoing value regarding the scribe lines L1 and L2. In addition, burrs are unlikely to be formed when the ceramic plate 100 is divided by adjusting the upper limit value for the first bending strength N1 to the foregoing value regarding the scribe lines L1 and L2. Therefore, the ceramic plate 100 described above is useful for achieving both stable quality of a circuit board and improvement in yield rate.

The longest length (opening size r) of each of the plurality of holes 20 in a direction orthogonal to the scribe lines L1 and L2 on the main surface 100A may be 50 µm to 120 µm, the depth d of each of the plurality of holes 20 may be 1/6 times to 1/3 times the thickness T of the ceramic plate 100, and the array pitch p of the plurality of holes 20 along the scribe lines L1 and L2 may be 50 µm to 120 µm. Regarding the scribe lines L1 and L2, in addition to adjustment of the bending strength, the opening size r of the hole, the depth d of the hole, and the array pitch p of the holes 20 are adjusted within the foregoing range, and thus cracking in the ceramic plate 100 in succeeding steps and forming of burrs when being divided are more reliably curbed. For this reason, it is more useful for achieving both stable quality of a circuit board and improvement in yield rate.

The method for manufacturing the ceramic plate 100 according to the foregoing embodiment includes the step of selecting a setting condition from the processing conditions for forming the scribe lines L1 and L2 constituted by the plurality of holes 20 on the main surface 100A of the ceramic plate 100, and the step of forming the scribe lines L1 and L2 using a laser beam on a surface of a base material for the ceramic plate 100 in accordance with the setting condition. The processing conditions each include the longest length (opening size r) of each of the plurality of holes 20 in a direction orthogonal to the scribe lines L1 and L2 on the main surface 100A, the depth d of each of the plurality of holes 20, and the array pitch p of the plurality of holes 20 along the scribe lines L1 and L2. The step of selecting a setting condition includes forming a plurality of ceramic plates for evaluation in a state where the scribe lines for evaluation constituted by the plurality of holes 20 are formed on one main surface while the processing conditions are varied, and selecting a condition having the first bending strength N1 being 380 MPa or greater and 0.56 times or less the second bending strength N2 from the varied processing conditions as the foregoing setting condition by evaluating the bending strength of each of the plurality of ceramic plates for evaluation.

In this manufacturing method, the processing condition having the first bending strength N1 being 380 MPa or greater and 0.56 times or less the second bending strength N2 is selected. For this reason, in the ceramic plate 100 having the scribe lines L1 and L2 formed therein in accordance with the selected processing condition, the first bending strength N1 can be adjusted within the foregoing range. If the first bending strength N1 is 380 MPa or greater, the ceramic plate is unlikely to crack in various steps after the scribe lines are formed, and if the first bending strength N1 is 0.56 times or less the second bending strength N2, burrs are unlikely to be formed after being divided. Therefore, this manufacturing method is useful for achieving both stable quality of a circuit board formed using the ceramic plate and improvement in yield rate.

Hereinabove, some embodiments of the present disclosure have been described, but the present disclosure is not limited to the foregoing embodiments in any way. For example, there is no need for the shapes of the conductive portions 250 provided in each of the partition portions 10 to be the same and may have different shapes for each of the partition portions 10. In addition, the ceramic plate 100 and the composite substrate may have a shape other than a quadrangular prism shape.

The conductive portions 250 in the circuit board 300 may be subjected to arbitrary surface treatment. For example, a part on surfaces of the conductive portions 250 may be covered with a protective layer such as a solder resist, and another part on the surfaces of the conductive portions 250 may be subjected to plating treatment.

In the example described above, when the setting condition is selected, a plurality of evaluation samples are produced for each one of the processing conditions, but one evaluation sample may be produced for each one of the processing conditions.

### Reference Signs List

100 Ceramic plate
100A, 100B Main surface
20 Hole
L1, L2 Scribe line
r Opening size of hole
d Depth of hole
T Thickness of ceramic plate
p Array pitch of plurality of holes

## Claims

1. A ceramic plate comprising:
a first main surface and a second main surface; and
a scribe line constituted by a plurality of holes formed on the first main surface,
wherein when a first bending strength is a value measured by a three-point bending test in a state where at least a part of the ceramic plate is disposed such that the first main surface is supported at two fulcrums and the scribe line lies along a load point applied to the second main surface, and when a second bending strength is a value measured by a three-point bending test in a state where at least a part of the ceramic plate is disposed such that the scribe line is not present between two fulcrums, the first bending strength is 380 MPa or greater and 0.56 times or less the second bending strength.

2. The ceramic plate according to claim 1,
wherein a longest length of each of the plurality of holes in a direction orthogonal to the scribe line on the first main surface is 50 µm to 120 µm,
wherein a depth of each of the plurality of holes is 1/6 times to 1/3 times a thickness of the ceramic plate, and
wherein a pitch of the plurality of holes along the scribe line is 50 µm to 120 µm.

3. A method for manufacturing a ceramic plate comprising:
a step of selecting a setting condition from a plurality of processing conditions for forming a scribe line constituted by a plurality of holes on a main surface of a ceramic plate; and
a step of forming the scribe line using a laser beam on a surface of a base material for the ceramic plate in accordance with the setting condition,
wherein each of the plurality of processing conditions includes a longest length of each of the plurality of holes in a direction orthogonal to the scribe line on the main surface, a depth of each of the plurality of holes, and a pitch of the plurality of holes along the scribe line,
wherein the step of selecting the setting condition includes
forming a plurality of ceramic plates for evaluation in accordance with the plurality of processing conditions, each of the plurality of ceramic plates including a scribe line for evaluation constituted by a plurality of holes and formed on one main surface, and
selecting a condition having a first bending strength being 380 MPa or greater and 0.56 times or less a second bending strength from the plurality of processing conditions as the setting condition by evaluating a bending strength of each of the plurality of ceramic plates for evaluation,
wherein the first bending strength is a value measured by a three-point bending test in a state where at least a part of the ceramic plate for evaluation is disposed such that the one main surface including the scribe line for evaluation formed thereon is supported at two fulcrums and the scribe line for evaluation lies along a load point applied to the other main surface opposite to the one main surface including the scribe line for evaluation formed thereon, and
wherein the second bending strength is a value measured by a three-point bending test in a state where at least a part of the ceramic plate for evaluation is disposed such that the scribe line for evaluation is not present between two fulcrums.
